# Europäisches Patentamt

## European Patent Office

## Office européen des brevets

(19)

(11) Veröffentlichungsnummer: **0 136 609**
**B1**

(12) ## EUROPÄISCHE PATENTSCHRIFT

(45) Veröffentlichungstag der Patentschrift:
**27.01.88**

(51) Int. Cl.⁴: **G 01 R 31/28**

(21) Anmeldenummer: **84111010.9**

(22) Anmeldetag: **14.09.84**

(54) Verfahren zur Lokalisierung von zeitkritischen Vorgängen im Innern einer getakteten elektronischen Schaltung.

(30) Priorität: **30.09.83 DE 3335671**

(43) Veröffentlichungstag der Anmeldung:
**10.04.85 Patentblatt 85/15**

(45) Bekanntmachung des Hinweises auf die Patenterteilung:
**27.01.88 Patentblatt 88/4**

(84) Benannte Vertragsstaaten:
**AT BE CH DE FR GB IT LI LU NL SE**

(56) Entgegenhaltungen:
**EP - A - 0 081 295**
**DE - A - 3 040 733**
**DE - A - 3 104 121**

(73) Patentinhaber: **Siemens Aktiengesellschaft Berlin und München, Wittelsbacherplatz 2, D-8000 München 2 (DE)**

(72) Erfinder: **Lassman, Reiner, Rainfarnstrasse 9, D-8000 München 45 (DE)**
Erfinder: **Krupp, Albert, Dipl.-Ing., Rauheckstrasse 12, D-8000 München 21 (DE)**
Erfinder: **Fazekas, Peter, Dipl.-Ing., Stuntzstrasse 21, D-8000 München 80 (DE)**

## Beschreibung

Die Erfindung betrifft ein Verfahren zur Lokalisierung von zeitkritischen Vorgängen im Innern einer getakteten elektronischen Schaltung nach dem Oberbegriff des Anspruchs 1.

Eine nicht-gepulste Elektronensonde ist geeignet, logische Zustände an internen Knoten integrierter Schaltungen zu erfassen. Während der Überprüfung eines internen Messpunktes wird die Sonde auf diesen Messpunkt positioniert und es wird eine Prüfmusterfolge an die Eingänge der integrierten Schaltung angelegt. Bei Verwendung einer Elektronensonde beträgt die Einschwingzeit eines mit der Elektronensonde erzielten Messignals beispielsweise 1 ms. Daher muss der zeitliche Abstand zweier aufeinanderfolgender Prüfmuster einige Millisekunden dauern, um eine genaue Bewertung des von dem internen Messpunkt der integrierten Schaltung abgenommenen Signals sicherzustellen. Weil der zeitliche Abstand zweier Prüfmuster bei diesem bekannten Verfahren mit einer nicht-gepulsten Elektronensonde einige Millisekunden betragen muss, ist ein solches bekanntes Verfahren nur geeignet für getaktete synchrone Schaltungen mit einer relativ niedrigen Taktfrequenz. Bei einem solchen langsamen Betrieb ist keine Aussage über das zeitliche Verhalten einer elektronischen Schaltung mit einer Taktfrequenz grösser als 1 kHz möglich.

Dynamische Vorgänge in integrierten Schaltungen wurden bisher mit einem Sampling-Verfahren erfasst (US-Patentschrift 4 220 854). Bei einem solchen Sampling-Verfahren muss jedoch eine zyklische Prüfmusterfolge verwendet werden, die nur eine geringe Länge aufweisen darf. Die Verwendung einer zyklischen Prüfmusterfolge geringer Länge ist jedoch nicht zum Testen einer jeden elektronischen Schaltung geeignet, beispielsweise wenig geeignet zum Testen einer logischen Schaltung mit vielen sequentiellen Stufen.

Aus der deutschen Offenlegungsschrift DE-AI 3 104 121 ist ein Verfahren zur Früherkennung von Halbleiterausfällen bekannt. Durch ein Absenken der Betriebsspannung und das Erhöhen der Arbeits- bzw. Taktfrequenz des untersuchten Bauelementes können insbesondere Kristalldefekte, Fehler in der Metallisierung sowie die durch Oberflächeneinflüsse hervorgerufenen Parameterverschiebungen erkannt werden.

Der vorliegenden Erfindung liegt die Aufgabe zugrunde, ein Verfahren der eingangs genannten Art anzugeben, mit dem zeitkritische Vorgänge im Innern von getakteten integrierten Schaltungen lokalisiert werden können, ohne dass ein zyklischer Betrieb notwendig wäre.

Diese Aufgabe wird erfindungsgemäss durch ein Verfahren nach dem Anspruch 1 gelöst.

Ausgestaltungen und Vorteile der Erfindung sind in den Unteransprüchen, der Beschreibung und der Zeichnung dargestellt.

Die Erfindung ist zwar anhand einer Elektronenstrahlsonde näher erläutert, kann jedoch auch bei Verwendung eines Laser-Scanners oder einer anderen Sonde benutzt werden.

Wesentlich für die Erfindung ist, dass durch Messungen an den Anschlüssen der zu untersuchenden elektronischen Schaltungen die Grenzfrequenz dieser Schaltung bestimmt wird. Sodann wird eine Prüfmusterfolge an die zu untersuchende Schaltung angelegt, und zwar mit einer Frequenz, die grösser ist als die zuvor ermittelte Grenzfrequenz und die daher mit Sicherheit zu einem Fehler an den Ausgängen führen wird. Bei einem bestimmten Prüfmuster mit den Nummer n aus dieser Prüfmusterfolge wird zum ersten Mal ein Fehler an einem Ausgang der Schaltung erkannt. Um nun herauszufinden, bei welchem Prüfmuster dieser beim Prüfmuster mit der Nummer n am Ausgang der Schaltung erkannte Fehler im Innern der Schaltung erzeugt worden ist, wird in mindestens einem Durchlauf die nunmehr auf die ersten n Prüfmuster reduzierte Prüfmusterfolge derart an die Schaltung angelegt, dass bei jedem Durchlauf der Prüfmusterfolge die Prüfmuster bis zur Nummer n-m (m bezeichnet eine natürliche Zahl kleiner n) mit einer Frequenz angelegt werden, die über der Grenzfrequenz liegt, und dass die restlichen m Prüfmuster der reduzierten Prüfmusterfolge mit einer Frequenz angelegt werden, die kleiner als die Grenzfrequenz ist. Im ersten Durchlauf der reduzierten Prüfmusterfolge nimmt m den Wert 1 an, im zweiten Durchlauf den Wert 2 und so weiter. Nach jedem Durchlauf der reduzierten Prüfmusterfolge wird geprüft, ob sich der bei demjenigen Verfahrensschritt, bei dem sämtliche Prüfmuster mit einer Frequenz grösser als die Grenzfrequenz angelegt worden sind, mit der Nummer n erkannte Fehler im Prüfmuster noch am Ausgang zeigt. Solange dasjenige Prüfmuster n-M (M bezeichnet eine natürliche Zahl kleiner n), bei dem zum ersten Mal im Innern der Schaltung ein Fehler erzeugt wird, mit einer Frequenz grösser als die Grenzfrequenz an die Schaltung angelegt wird, wird beim Prüfmuster n ein dadurch bedingter Fehler am Ausgang festgestellt werden. Wenn dieses Prüfmuster mit der Nummer n-M zum ersten Mal mit einer Frequenz kleiner als die Grenzfrequenz der Schaltung an diese Schaltung angelegt wird, wird am Ausgang der Schaltung kein dadurch bedingter Fehler mehr nachgewiesen werden können. Sollten im Innern einer Schaltung mehr als eine Fehlerursache vorliegen, so müssen solange immer mehr Prüfmuster mit einer Frequenz kleiner als die Grenzfrequenz an die Schaltung angelegt werden, bis überhaupt kein Fehler mehr am Ausgang der Schaltung nachgewiesen werden kann. Mit einem erfindungsgemässen Verfahren kann sodann eine erste Fehlerursache identifiziert werden, und können nach Beseitigung dieser Fehlerursache schrittweise weitere Fehlerursachen identifiziert und beseitigt werden. Vor Anlegen einer jeden Prüfmusterfolge muss die Schaltung initialisiert werden.

Wenn festgestellt worden ist, dass bei einem Prüfmuster mit der Nummer n-M im Innern der Schaltung ein Fehler erzeugt worden ist, gibt es mehrere Möglichkeiten, die Fehlerursache herauszufinden. Da der beim Prüfmuster mit der Nummer n-M erzeugte Fehler erst beim Prüfmuster mit der Nummer n am Ausgang der Schaltung festgestellt werden kann, liegt die Fehlerursache um M sequentielle Stufen von diesem Ausgang entfernt. Da die Prüfmuster mit der Nummer n-M und n-M-1 bekannt sind, und da bekannt ist, dass das Prüfmuster mit der Nummer n-M am kritischen Schaltelement wirksam wird, das Prüfmuster mit der Nummer n-M-1 jedoch nicht mehr, kann anhand der Schaltungsliste eingegrenzt werden, welche möglichen Fehlerursachen in Frage kommen. Mit Hilfe einer Sonde oder mit Hilfe von Registern, die mit Anschlüssen an in Frage kommende möglicherweise fehlerbehaftete kritische Schaltelemente versehen sind, oder über Anlegen von weiteren Prüfmustern kann sodann gezielt die Fehlerursache herausgefunden werden.

Eine weitere Möglichkeit, eine Fehlerursache herauszufinden, besteht in der Verwendung einer sogenannten Fehlerpfadverfolgung. In mindestens einem Durchlauf werden dabei jeweils n-M Prüfmuster mit einer Frequenz grösser als die Grenzfrequenz und weitere M-p Prüfmuster mit einer Frequenz kleiner als die Grenzfrequenz an die Schaltung angelegt. Beim ersten Durchlauf nimmt p den Wert 0 an, beim zweiten Durchlauf den Wert 1 und so weiter. Beim ersten Durchlauf tritt der beim Prüfmuster mit der Nummer n-M verursachte Fehler beim Prüfmuster mit der Nummer n am Ausgang der Schaltung auf. Beim zweiten Durchlauf tritt dieser Fehler um eine sequentielle Stufe entfernt von diesem fehlerbehafteten Ausgang auf. Im Durchlauf mit der Nummer $p+1$ tritt der Fehler um p sequentielle Stufe vom fehlerbehafteten Ausgang auf. Der dabei vorhandene Fehlerpfad wird mit einer Sonde verfolgt.

Die Erfindung wird im folgenden anhand der Zeichnung näher erläutert.

Fig. 1 mit 3 erläutern das der Erfindung zugrundeliegende Prinzip.

Fig. 4 erläutert das Beispiel einer Fehlerpfadverfolgung.

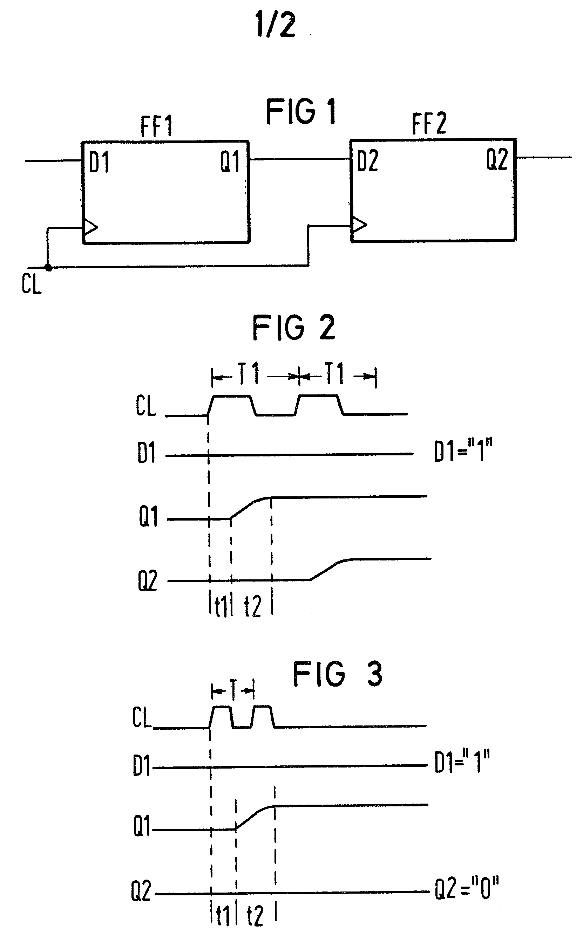

In den Fig. 1 mit 3 ist das der Erfindung zugrundeliegende Prinzip erläutert. Fig. 1 zeigt ein Beispiel einer einfachen synchronen Schaltung. Diese Schaltung besteht aus zwei flankengesteuerten D-Flipflops FF1, FF2 und arbeitet bis zu beliebig niedrigen Taktfrequenzen fehlerfrei. Die obere Grenzfrequenz fa dieser Schaltung ist zum einen durch die Signallaufzeiten innerhalb der Schaltelemente FF1, FF2, sowie die zugeordneten Verbindungspfade, zum anderen durch die Anstiegs- bzw. Abfallzeiten der Signale bestimmt. Die Grenzfrequenz fa dieser Schaltung ergibt sich als diejenige Taktfrequenz, bei der der zeitliche Abstand Ta zwischen zwei aufeinanderfolgenden Taktimpulsen gleich der Summe aus Verzögerungszeit t1 und Anstiegszeit t2 desjenigen Schaltelementes der Schaltung ist, das den grössten Summenwert für die Summe aus Verzögerungszeit t1 und Anstiegszeit t2 aufweist.

Zur Lokalisierung von zeitkritischen Vorgängen im Innern von getakteten integrierten Schaltungen kann beispielsweise eine Elektronensonde verwendet werden. Die Verwendung einer Elektronensonde zur Bewertung von logischen Pegeln ist in der US-Patentschrift 4 277 679 angegeben. Da bei Verwendung einer Elektronensonde die Einschwingzeit des Messignals einige Millisekunden betragen kann, ist zur sicheren Signalbewertung bei Verwendung einer Elektronensonde eine Unterbrechung des Taktes CL über die notwendige Signalbewertungszeit hinweg erforderlich. Andererseits werden für ein am Eingang D1 angelegtes Prüfmuster die beiden zugehörigen Ausgangssignale Q1 und Q2 benötigt. Weiter muss der Durchgang des am Eingang D1 angelegten Prüfmusters durch die Schaltung von Fig. 1 hindurch bei Frequenzen grösser und kleiner als die Grenzfrequenz fa untersucht werden, um eine mögliche Fehlerursache herausfinden zu können. Im Beispiel nach Fig. 1 wird daher ein und dasselbe Prüfmuster am Eingang D1 während zweier aufeinanderfolgender Taktimpulse angelegt und wird der Takt CL nach Ablauf dieser beiden Taktimpulse unterbrochen, damit Gelegenheit gegeben ist, die Elektronensonde jeweils auf einen Messpunkt mit dem Signal Q1 und einen weiteren Messpunkt mit dem Signal Q2 positionieren zu können und Aussagen über die Funktion der Schaltung treffen zu können. Durch Anlegen des Prüfmusters am Eingang D1 und des Taktes CL in Doppelschritten und eine darauffolgende Signalbewertung von zwei Signalen Q1, Q2, die in aufeinanderfolgenden sequentiellen Stufen angeordnet sind, können bei synchronen Schaltungen zeitkritische Vorgänge quasistatisch bestimmt werden.

Wird der zeitliche Abstand T1 zweier aufeinanderfolgender Taktimpulse ausreichend gross gewählt, wie dies in Fig. 2 dargestellt ist, so arbeitet die Schaltung von Fig. 1 fehlerfrei. Im zweiten Takt nimmt das Signal Q2 den logischen Wert 1 an.

Wird der zeitliche Abstand T zweier aufeinanderfolgender Taktimpulse kleiner als die Summe der Verzögerungszeit t1 und der Anstiegszeit t2 gewählt, wie dies in Fig. 3 gezeigt ist, so wird durch den zweiten Taktimpuls das Ausgangssignal Q2 des Flipflops FF2 nicht auf den logischen Wert 1 gesetzt. Die auf die beiden Takte folgende Signalbewertung zeigt dann, dass am Ausgang Q2 ein Fehler vorliegt. Bei einem Verfahrensbeispiel nach den Fig. 1 mit 3 muss jedes Prüfmuster jeweils in zwei aufeinanderfolgenden Takten an die Schaltung angelegt werden.

Ein Verfahren nach den Fig. 1 mit 3 kann auch so erfolgen, dass der Takt CL nach jeweils zwei aufeinanderfolgenden Takten zur Signalbewertung unterbrochen wird und dass die Prüfmuster nach jedem Taktimpuls wechseln. Auf diese Weise wird das zeitliche Verhalten der Schaltung von Fig. 1 nach jedem zweiten Prüfmuster untersucht. Dann sind zwei Durchläufe notwendig, einer zur Untersuchung einer Hälfte der Messignale, ein zweiter für die Untersuchung der zweiten Hälfte der Messignale. Es kann auch eine beliebige Auswahl von Messignalen getroffen werden.

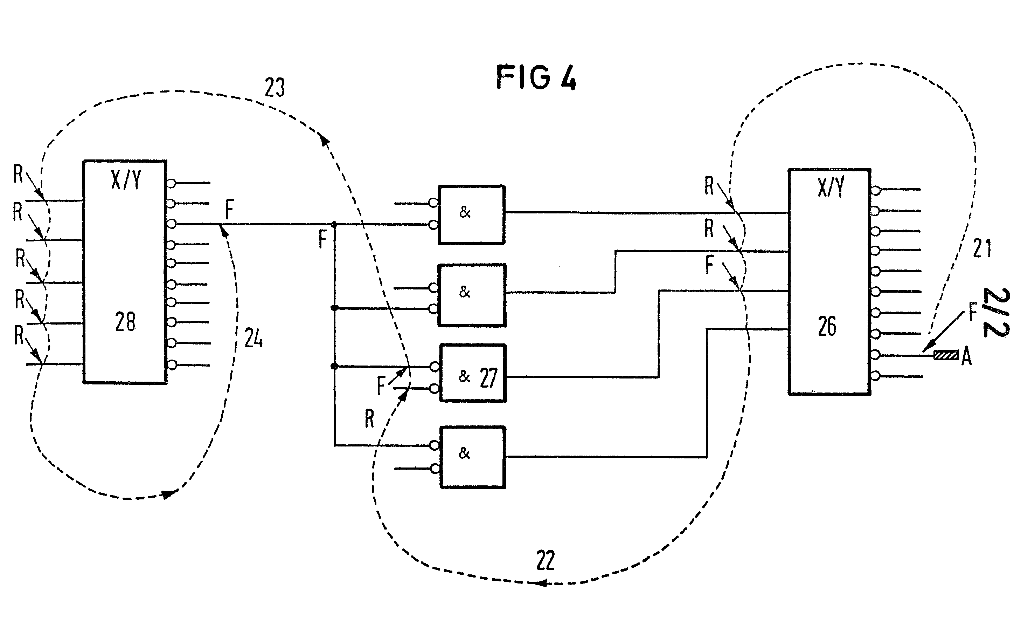

Fig. 4 erläutert ein Beispiel für eine Fehlerpfadverfolgung. Dabei wird zunächst durch Messungen an den Ausgängen der Schaltung die Grenzfrequenz fa der Schaltung bestimmt, z.B. zu 5 MHz. Sodann wird eine Prüfmusterfolge an diese Schaltung angelegt. Dabei wird dasjenige Prüfmuster mit der Nummer n bestimmt, bei dem zum ersten Mal ein Fehler an den Ausgängen der Schaltung erkannt wird, und zwar bei einer Frequenz grösser als die Grenzfrequenz fa, z.B. bei 5,5 MHz. Dann wird untersucht, bei welchem Prüfmuster der Fehler im Innern der Schaltung erzeugt wird. Dies geschieht beispielsweise in mehreren Durchläufen. Die Prüfmuster werden bis zur Nummer n-m mit der Frequenz grösser als die Grenzfrequenz fa angelegt. Die restlichen m Prüfmuster werden mit einer Frequenz kleiner als die Grenzfrequenz fa angelegt, z.B. mit 4,5 MHz. Nach jedem Durchlauf der n Prüfmuster wird geprüft, ob sich der Fehler noch am Ausgang zeigt. m wird in Schritten von 1 solange erhöht, bis sich am Ausgang der Schaltung kein Fehler mehr nachweisen lässt. Dies ist dann der Fall, wenn die schnelle Folge der Prüfmuster, die mit einer Frequenz grösser als die Grenzfrequenz fa angelegt wird, am kritischen Schaltelement nicht mehr wirksam wird. Beispielsweise lässt sich zum ersten Mal kein Fehler mehr am Ausgang der Schaltung für m=M+1 nachweisen.

Bei der Fehlerpfadverfolgung werden n-M Prüfschritte mit einer Frequenz grösser als die Grenzfrequenz fa angeboten. Dabei wird ein Fehler im Innern der Schaltung erzeugt. Diese n-M Prüfmuster werden bei jedem Prüfmusterdurchlauf zuerst an die Schaltung angelegt. Im ersten Prüfmusterdurchlauf werden sodann M weitere Prüfmuster mit einer Frequenz kleiner als die Grenzfrequenz fa an die Schaltung angelegt. Am Ende des ersten Prüfmusterdurchlaufes ist ein Fehler F am Ausgang A vorhanden und kann beispielsweise mit der Elektronensonde in einer bestimmten Bewertungszeit als solcher festgestellt werden. Es wird ermittelt, dass dieser fehlerhafte Ausgang A von einem Ausgang des Schaltelementes 26 gespeist wird. In einem zweiten Prüfmusterdurchlauf werden zusätzlich zu den ersten n-M Prüfmustern weitere M-1 Prüfmuster angelegt. In einem nächsten Schritt 21 werden sämtliche Eingänge des Schaltelementes 26 ermittelt und nach dem zweiten Prüfmusterdurchlauf überprüft. Wird dabei ein gestörter Eingang dieses Schaltelementes 26 festgestellt, so wird dasjenige Schaltelement 27 ermittelt, dessen Ausgang diesen gestörten Eingang des Schaltelementes 26 speist. In einem dritten Prüfmusterdurchlauf werden zusätzlich zu den n-M Prüfmustern weitere M-2 Prüfmuster angelegt. In einem weiteren Prüfschritt 22 werden sodann beispielsweise mit Hilfe einer Elektronensonde die Eingänge des Schaltelementes 27 ermittelt und überprüft. Wird dabei wiederum ein gestörter Eingang dieses Schaltelementes 27 festgestellt, so wird ermittelt, dass ein Ausgang des Schaltelementes 28 diesen gestörten Eingang des Schaltelementes 27 speist. In einem vierten Prüfmusterdurchlauf werden zusätzlich zu den ersten n-M Prüfmustern weitere M-3 Prüfmuster angelegt. Die weiteren Prüfmuster werden wie bei jedem Prüfmusterdurchlauf mit einer Frequenz kleiner als die Grenzfrequenz fa angelegt. Die ersten n-M Prüfmuster werden wie in jedem Prüfmusterdurchlauf mit einer Frequenz grösser als die Grenzfrequenz fa angelegt.

In einem weiteren Prüfschritt 23 werden nunmehr die Eingänge des Schaltelementes 28 ermittelt und überprüft. Da in dem Beispiel von Fig. 4 sämtliche Eingänge des Schaltelementes 28 ungestört sind, wird in einem weiteren Prüfschritt 24 derjenige Ausgang des Schaltelementes 28 ermittelt und überprüft, der zum gestörten Eingang des Schaltelementes 27 führt. Da dieser Ausgang des Schaltelementes 28 sich in dem Beispiel von Fig. 4 als gestört erweist, ist das Schaltelement 28 ausschliesslich der zugeordneten Verbindungspfade als Fehlerursache lokalisiert. Gestörte Punkte sind in Fig. 4 mit F bezeichnet, ungestörte Punkte sind mit R angegeben. Die Schaltelemente können speichernd und nicht-speichernd sein.

**Patentansprüche**

1. Verfahren zur Lokalisierung von zeitkritischen Vorgängen im Innern einer getakteten elektronischen Schaltung, dadurch gekennzeichnet, dass

a) durch Messung an den Ausgängen (A) die Grenzfrequenz (fa) der Schaltung ermittelt wird,

b) eine Prüfmusterfolge an die Schaltung angelegt wird,

c) die Nummer n desjenigen Prüfmusters ermittelt wird, bei dem ein Fehler (F) an den Ausgängen (A) erkannt wird, und zwar bei einer Taktfrequenz, die grösser als die ermittelte Grenzfrequenz (fa) der Schaltung ist,

d) die Prüfmuster mit den Nummern n-m mit einer Taktfrequenz, die grösser als die ermittelte Grenzfrequenz (fa) der Schaltung ist, und die restlichen m Prüfmuster mit einer Taktfrequenz, die kleiner als die ermittelte Grenzfrequenz (fa) der elektronischen Schaltung, schrittweise mit m=1, 2, 3; .., in mindestens einem Durchlauf von n Prüfmustern hintereinander an die Schaltung angelegt werden, wobei nach jedem Durchlauf einer Prüfmusterfolge von n Prüfmustern geprüft wird, ob der Fehler (F) am Ausgang (A) noch vorliegt, solange bis sich kein Fehler (F) mehr am Ausgang (A) nachweisen lässt, und damit ermittelt ist, bei welchem Prüfmuster mit der Nummer n-M der Fehler im Innern der Schaltung erzeugt wird,

e) ein Element der Schaltung lokalisiert wird, an dem das Prüfmuster der Nummer n-M während des Auftretens eines Fehlers (F) an einem der Ausgänge (A) wirksam ist.

2. Verfahren nach Anspruch 1, dadurch gekennzeichnet, dass eine Fehlerpfadverfolgung durchgeführt wird, wobei

a) in mindestens einem Prüfmusterdurchlauf jeweils n-M Prüfmuster mit einer Frequenz grösser als die Grenzfrequenz (fa) an die Schaltung angelegt werden,

b) in jedem Prüfmusterdurchlauf zusätzlich weitere M-p Prüfmuster, mit p=0, 1, 2; . .., mit einer Frequenz kleiner als die Grenzfrequenz (fa) an die Schaltung angelegt werden,

c) nach jedem Prüfmusterdurchlauf, bei denen p jeweils um 1 schrittweise erhöht wird, von einem im vorhergehenden Prüfmusterdurchlauf als fehlerhaft erkannten logischen Zustand des Ausgangs eines Schaltelementes (26, 27, 28) ausgehend geprüft wird, ob wenigstens ein fehlerhafter logischer Zustand des Eingangs zu diesem Schaltelement (26, 27, 28) vorhanden ist,

d) wenigstens ein Schaltelement (28) als fehlerverursachend bestimmt wird, das einen fehlerhaften logischen Zustand des Ausgangs und keinen fehlerhaften logischen Zustand des Eingangs aufweist.

3. Verfahren nach Anspruch 1 oder 2, dadurch gekennzeichnet, dass vom fehlerhaften logischen Zustand des Ausgangs (A) der Schaltung ausgehend um m sequentielle Stufen zurückgegangen wird und dass dort alle als Fehlerursache in Frage kommenden Schaltelemente auf richtige Funktion hin überprüft werden.

4. Verfahren nach einem der Ansprüche 1 bis 3, dadurch gekennzeichnet, dass nur solche Schaltelemente überprüft werden, bei denen das Prüfmuster mit der Nummer n-M wirksam wird.

5. Verfahren nach einem der Ansprüche 1 bis 4, dadurch gekennzeichnet, dass die als mögliche Fehlerursachen in Frage kommenden Schaltelemente einschliesslich der zugeordneten Verbindungspfade gezielt durch zusätzliche Prüfmuster auf ihre Funktion hin überprüft werden.

6. Verfahren nach einem der Ansprüche 1 bis 5, dadurch gekennzeichnet, dass Signalwerte von inneren Schaltungsknoten über ein Register abgenommen werden.

7. Verfahren nach einem der Ansprüche 1 bis 6, dadurch gekennzeichnet, dass Signalwerte von inneren Schaltungsknoten mit Hilfe von mindestens einer Sonde abgenommen werden.

8. Verfahren nach Anspruch 7, dadurch gekennzeichnet, dass Signalwerte von mindestens einer Elektronensonde abgenommen werden.

9. Verfahren nach Anspruch 7 oder 8, dadurch gekennzeichnet, dass Signalwerte von mindestens einem Laser-Scanner abgenommen werden.

10. Verfahren nach einem der Ansprüche 1 bis 9, dadurch gekennzeichnet, dass nach mindestens zwei Taktimpulsen, jedoch vor Beendigung eines Prüfmusterdurchlaufes, Signale an inneren Schaltungsknoten abgenommen werden.

11. Verfahren nach Anspruch 10, dadurch gekennzeichnet, dass zu verschiedenen Zeiten abgenommene Signale gespeichert und miteinander verglichen werden, wodurch auf die logische Funktion von Schaltelementen geschlossen wird.

**Revendications**

1. Procédé pour localiser des processus critiques dans le temps à l'intérieur d'un circuit électronique commandé de façon cadencée, caractérisé par le fait que

a) on détermine la fréquence limite (fa) du circuit au moyen d'une mesure effectuée sur les sorties (A),

b) on applique au circuit une succession de profils de contrôle,

c) on détermine le numéro n du profil de contrôle, pour lequel une erreur (F) est identifiée sur les sorties (A), et ce pour une fréquence d'horloge, qui est supérieure à la fréquence limite (fa) déterminée du circuit,

d) on applique au circuit successivement et pas-à-pas, avec m=1, 2, 3; . .., selon au moins un cycle de n profils de contrôle, les profils de contrôle possédant les numéros n-m avec une fréquence d'horloge qui est supérieure à la fréquence limite déterminée (fa) du circuit, et les m profils de contrôle restants avec une fréquence d'horloge qui est inférieure à la fréquence limite déterminée (fa) du circuit électronique, auquel cas après chaque cycle formé d'une suite contenant n profils de contrôle, on contrôle si l'erreur (F) est encore présente sur la sortie (A), jusqu'à ce qu'une erreur (F) ne puisse plus être décelée sur la sortie (A), et on détermine de ce fait pour quel profil de contrôle portant le numéro n-M l'erreur est produite à l'intérieur du circuit,

e) on localise un élément du circuit, dans lequel le profil de contrôle portant le numéro n-M agit pendant l'apparition d'une erreur (F) sur l'une des sorties (A).

2. Procédé suivant la revendication 1, caractérisé par le fait qu'on réalise un suivi du trajet de circulation de l'erreur, auquel cas:

a) pendant au moins un cycle de profils de contrôle on applique au circuit respectivement n-M profils de contrôle avec une fréquence supérieure à la fréquence limite (fa),

b) pendant chaque cycle de profils de contrôle, on applique en outre au circuit M-p profils de contrôle supplémentaires, avec p=0, 1, 2; . .., avec une fréquence inférieure à la fréquence limite (fa),

c) après chaque cycle de profils de contrôle, lors duquel p est accru respectivement pas-à-pas de 1, on contrôle, à partir d'un état logique, identifié comme erroné pendant le cycle précédent de profils de contrôle, de la sortie d'un élément de circuit (26, 27, 28), s'il existe au moins un état logique erroné de l'entrée de cet élément de circuit (26, 27, 28),

d) on détermine comme étant la cause de l'erreur au moins un élément de circuit (28), dont la sortie possède un état logique erroné et dont l'entrée ne présente pas un état logique erroné.

3. Proccédé suivant la revendication 1 ou 2, caractérisé par le fait qu'on exécute un cycle rétrograde sur m échelons successifs à partir de l'état logique erroné de la sortie (A) du circuit et que l'on contrôle, dans ces échelons, si tous les éléments de circuit, qui entrent en jeu en tant que cause d'une erreur, possèdent un fonctionnement correct.

4. Procédé suivant l'une des revendications 1 à 3, caractérisé par le fait qu'on contrôle uniquement les éléments de circuit pour lesquels le profil de contrôle possédant le numéro n-M devient actif.

5. Procédé suivant l'une des revendications 1 à 4, caractérisé par le fait que l'on contrôle, de façon voulue, le fonctionnement des éléments de circuit, qui interviennent en tant que causes possibles d'erreur, y compris les voies de liaison associées, à l'aide de profils de contrôle supplémentaires.

6. Procédé suivant l'une des revendications 1 à 5, caractérisé par le fait qu'on prélève des valeurs de signaux de nœuds intérieurs du circuit par l'intermédiaire d'un registre.

7. Procédé suivant l'une des revendications 1 à 6, caractérisé par le fait qu'on prélève des valeurs de signaux de nœuds intérieurs du circuit à l'aide d'au moins une sonde.

8. Procédé suivant la revendication 7, caractérisé par le fait qu'on prélève des valeurs de signaux à l'aide d'au moins une sonde électronique.

9. Procédé suivant la revendication 7 ou 8, caractérisé par le fait qu'on prélève des valeurs de signaux à l'aide d'au moins un dispositif d'exploration à laser.

10. Procédé suivant l'une des revendications 1 à 9, caractérisé par le fait qu'on prélève des signaux au niveau de nœuds intérieurs du circuit après au moins deux impulsions d'horloge, mais avant un cycle de profils de contrôle.

11. Procédé suivant la revendication 10, caractérisé par le fait que l'on mémorise des signaux prélevés à des instants différents et qu'on les compare entre eux, ce qui permet de tirer des conclusions concernant le fonctionnement logique d'éléments de circuit.

**Claims**

1. A method of localising time-critical processes in a clock-controlled electronic circuit, characterised in that:

a) the cut-off frequency (fa) of the circuit is ascertained by measurement at the outputs (A);

b) a test pattern sequence is connected to the circuit;

c) in the case of a fault (F) being recognised at the outputs (A) the number n of the relevant test pattern is ascertained at a clock frequency greater than the determined cut-off frequency (fa) of the circuit;

d) the test patterns with the number n-m are connected to the circuit with a clock frequency greater than the determined cut-off frequency (fa) of the circuit, and the remaining m test patterns are connected with a clock frequency lower than the determined cut-off frequency (fa) of the electronic circuit, in stepped fashion where m=1, 2, 3; .., in at least one cycle of n test patterns, where following each cycle of a test pattern sequence of n test patterns a check is made to ascertain whether the fault (F) still occurs at the output (A), until there is no longer evidence of a fault (F) at the output (A), and thus the test pattern with the number n-M in the case of which the fault is produced in the circuit is thus determined; and

e) an element of the circuit is localised at which the test pattern bearing the number n-M is active during the occurrence of a fault (F) at one of the outputs (A).

2. A method as claimed in Claim 1, characterised in that fault path tracking is carried out, where:

a) in at least one test pattern cycle n-M test patterns are in each case connected to the circuit with a frequency greater than the cut-off frequency (fa);

b) in each test pattern cycle a further M-p test patterns, where p=0, 1, 2; .., are additionally connected to the circuit with a frequency lower than the cut-off frequency (fa);

c) following each test pattern cycle, in each of which p is increased in incremental fashion by 1, commencing from a logic status of the output of a circuit element (26, 27, 28) which has been recognised as faulty in the previous test pattern cycle, it is checked whether at least one faulty logic status of the input to this circuit element (26, 27, 28) exists; and

d) it is ascertained that faults are produced by at least one circuit element (28) which has a faulty logic status of the output and no faulty logic status of the input.

3. A method as claimed in Claims 1 or 2, characterised in that commencing from the faulty logic status of the output (A) of the circuit, a step-back of m sequential steps is effected at which point all the circuit elements likely to give rise to faults are checked to ensure that they are functioning correctly.

4. A method as claimed in one of Claims 1 to 3, characterised in that only those circuit elements are checked in the case of which the test pattern bearing the number n-M is active.

5. A method as claimed in one of Claims 1 to 4, characterised in that the circuit elements which are liable to give rise to faults, including the assigned connection paths, are purposively checked in respect of their functioning by actual test patterns.

6. A method as claimed in one of Claims 1 to 5, characterised in that signal values are obtained from internal circuit nodes via a register.

7. A method as claimed in one of Claims 1 to 6, characterised in that signal values are obtained from internal circuit nodes by means of at least one probe.

8. A method as claimed in Claim 7, characterised in that signal values are obtained by means of at least one electronic probe.

9. A method as claimed in Claims 7 or 8, characterised in that signal values are obtained by means of at least one laser scanner.

10. A method as claimed in one of Claims 1 to 9, characterised in that signals are obtained from internal circuit nodes following at least two clock pulses, but before the end of a test pattern cycle.

11. A method as claimed in Claim 10, characterised in that signals obtained at different times are stored and compared with one another, as a result of which information is obtained relating to the logic function of circuit elements.

FIG 1

FIG 2

FIG 3

FIG 4